Europäisches Patentamt

European Patent Office

Office européen des brevets

(11) Publication number: **0 157 881**
**B1**

# EUROPEAN PATENT SPECIFICATION

(45) Date of publication of patent specification: **29.03.89**

(51) Int. Cl.⁴: **G 01 R 15/02**

(21) Application number: **84903370.9**

(22) Date of filing: **11.09.84**

(86) International application number:
**PCT/JP84/00439**

(87) International publication number:
**WO 85/01355 28.03.85 Gazette 85/08**

(54) **CURRENT DETECTING CIRCUIT.**

(30) Priority: **13.09.83 JP 169701/83**

(43) Date of publication of application:
**16.10.85 Bulletin 85/42**

(45) Publication of the grant of the patent:
**29.03.89 Bulletin 89/13**

(84) Designated Contracting States:
**CH DE GB LI**

(56) References cited:
**CH-A- 537 085**
**DE-A- 970 574**
**JP-B-48 025 949**
**JP-B-50 002 044**
**US-A-3 031 600**
**US-A-3 815 013**
**US-A-4 255 705**

**IEEE TRANSACTIONS ON PARTS, HYBRIDS, AND PACKAGING, vol. PHP-11, no. 3, September 1975, pages 221-225, New York, US; T.W. MOODY: "A new method for current transformer loading"**

(73) Proprietor: **MITSUBISHI DENKI KABUSHIKI KAISHA**
**2-3, Marunouchi 2-chome Chiyoda-ku Tokyo 100 (JP)**

(72) Inventor: **TODA, Masayoshi Mitsubishi Denki Kabushiki**
**Kaisha Fukuyama Seisakusho 1-8, Midorimachi Fukuyama-shi Hiroshima 720 (JP)**

(74) Representative: **Kuhnen, Wacker & Partner Schneggstrasse 3-5 Postfach 1553 D-8050 Freising (DE)**

Courier Press, Leamington Spa, England.

## Description

Technical field

The present invention relates to a current detection circuit applicable for an electronic type electric energy metering apparatus and the like.

Background art

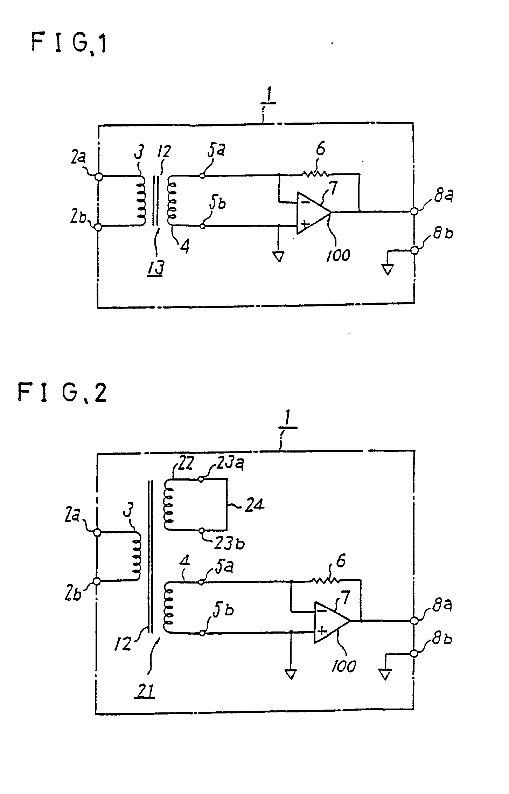

A known current detection means for measuring electric energy is such as that shown in Fig. 1. That is, numeral (1) is a current detection circuit. Numerals (2a), (2b) are input terminals for a current to be detected and are connected to a primary coil (3) of a current transformer (13). The current transformer (13) further has an iron core (12) and a secondary coil (4), and both ends of the secondary coil (4) are connected to a pair of terminals (5a), (5b) as output terminals of the current transformer (13). One of the output terminals (5a) is connected to an inverting input terminal (−) of an operational amplifier (7), and also connected through a feed-back resistor (6), which constitutes a current-voltage conversion circuit (100), to the output terminal (8a) of the current detection circuit (1) which is also an output terminal of the operational amplifier (7). The other output terminal (5b) is connected to a non-inverting input terminal (+) of the operational amplifier (7), and also connected to a reference potential and further connected to an output terminal (8b) of the current detection circuit (1).

In the above-constituted current detection circuit (1), it is arranged that the number of turns of the primary coil and the secondary coil are $N_1$ and $N_2$, respectively. Now, when a current $I_1$ is inputted to the input terminals (2a), (2b), a magnetomotive force of $N_1 \cdot I_1$ [AT] is generated in the primary coil (3). And a secondary current $I_2$ satisfying the equation

$$N_1 \cdot I_1 = N_2 \cdot I_2$$

flows in the secondary coil (4) in order to keep an equilibrium to the above-mentioned magnetomotive force. This secondary current $I_2$ flows in the resistor (6) by way of the output terminal (5a), since the input impedance of the operation amplifier (7) is very large. The other output terminal (5b) is connected to the non-inversion input terminal (+) of the operational amplifier (7) and also to the reference potential; and accordingly, provided that the direction of the above-mentioned current $I_2$ is in a direction of flowing out from the output terminal (5a), in case a resistance of the resistor (6) is R, the potential of the output terminal of the operational amplifier (7) falls to a potential of minus $R \cdot I_2$ [V] of the inversion input terminal (−), and makes a voltage between the non-inversion terminal (+) and the inversion terminal of the operational amplifier (7) $-R \cdot I_2/A$ [V], wherein A is a gain of the operational amplifier (7), to hold a circuit equilibrium. Since the gain A of the operational amplifier (7) is generally around $10^5$, the potential at the above-mentioned inverting terminal (−) becomes almost 0 [V], and the potential at the output terminal of the operational amplifier becomes $-R \cdot I_2$ [V]. Therefore, for the above-mentioned primary current, an output voltage $E_0$ proportional to the input current $I_1$ is obtainable by:

$$E_0 = -R \cdot I_2 = -R \frac{N_1}{N_2} \cdot I_1.$$

As a means analogous to the above-mentioned current-detection means, for instance, an apparatus which is shown in Fig. 1 of the United States Patent No. US—A—3875509 issued on April 1, 1975 to Miran Mikovic is known.

Also in US—A—3 815 013 a combination of a current transformer and a transresistance amplifier is disclosed. The secondary winding of the current transformer is connected to the input of the transresistance amplifier and is virtually short-circuited because of the very low input impedance of the transresistance amplifier. The transresistance amplifier, nevertheless, supplies an output voltage which is proportional to the current in the primary winding of the current transformer. An output voltage is developed from the current in the secondary winding.

However, the above-mentioned conventional circuit has the following problem:

That is, when current to be defected is large, for instance, in an electronic type electric energy metering apparatus, it is necessary to introduce a current of 200 [A] at maximum as a primary current to the current transformer (13), and in such case if a secondary current $I_2$ is intended to be fed from a general operational amplifier (7) through a resistor (6), the current is preferably not less than 5 [mA]. From this, provided that the secondary current $I_2$ when the primary current $I_1$ is made 200 [A] is, for instance, 2 [mA], ratio of number of turns of the current transformer (13) becomes

$$\frac{N_2}{N_1} = \frac{I_1}{I_2} = \frac{200 \text{ [A]}}{2 \times 10^{-3} \text{ [A]}} = 10^5,$$

and then, even though the number of turns of the primary coil is made 1 [T], the number of turns of the secondary coil is required to be 100,000 [T]. The current transformer which requires such coil has the following shortcomings as a result that the number of turns is very large:

(1) Space occupation rate of the coil is low, and a bulky core is required and the current transformer itself becomes large.

(2) A large amount of winding wire is necessary and material cost becomes expensive.

(3) Work of winding wire takes long time.

(4) Since a large amount of fine wire is wound, reliability is low.

Furthermore, when it is intended that the above-mentioned shortcoming is eliminated by using an operational amplifier (7) of a large current output type, such operational amplifier (7) consumes a very large electric power, and therefore using it in the electronic type electric energy metering apparatus wherein the whole circuit is intended to be operated with about 0.5 [W] becomes impossible.

From IEEE Transactions on Parts, Hybrids and Packaging, Vol. PHP-11, No. 3, September 1975, pages 221—225, New York, US; T. W. Moody: "A New Method for Current Transformer Loading" is known that separate windings for load and output functions can be used. The principal feature of this method is that the resistance of the load winding itself serves as the entire load for the device. Several means of achieving such a configuration are suggested, including the use of bifilar windings and single-turn load windings made with bare wire or conductive coatings placed directly on the core.

From DE—A—970 574 a current transformer is known having two secondary windings, the one winding being formed by a material having a resistance temperature coefficient different from the resistance temperature coefficient of the material forming the other winding, to make possible a temperature compensation of the current transformer response.

Disclosure of the invention

The present invention has a feature that output of a secondary coil is transformed into a very small current value which can be handled by semiconductor circuit, by utilizing a special current transformer which has a tertiary coil with its both ends electrically connected together as a means to detect a large current by an operational amplifier constituted with semiconductor devices. By this, there is no need of the transformer having the secondary coil of a very large turn number nor the operational amplifier of a large current output.

Accordingly, it is possible to obtain a current detector circuit which is small in size, easy to manufacture low in cost, highly reliable and has low power consumption.

Brief description of the drawing

Fig. 1 is the electric circuit showing the conventional current detection circuit, and Fig. 2 is an electric circuit diagram showing one embodiment of the present invention.

The best mode for embodying the present invention

Fig. 2 is an electric circuit showing one embodiment of the current detection circuit in accordance with the present invention, and therein, the same numerals are designated for the same parts as in Fig. 1 and elucidations therefore are omitted.

In Fig. 2, numeral (21) designates current transformer which has a primary coil (3) connected to a pair of input terminals (2a), (2b), an iron core (12), a secondary coil (4) and besides a tertiary coil (22). The tertiary coil (22) is connected to terminals (23a), (23b) which are short-circuited by a conductor (24).

Next, the operation of the above-mentioned construction is elucidated.

A current which is inputted to the input terminals (2a), (2b) is led to the primary coil (3) as the primary current $I_1$ of the current transformer (21). Opposing the primary current $I_1$, the currents $I_2$, $I_3$ flow in the secondary coil (4) and the tertiary coil (22), respectively. Now provided that in the secondary coil 4, the secondary current $I_2$ is in a direction to flow out of the terminal (5a), the secondary current $I_2$ does not flow in the inverting input terminal (−) of the operational amplifier (7) but flows to the output terminal of the operational amplifier (7) through the resistor (6), since the input impedance of the operational amplifier (7) is very large. Accordingly, the potential of the output terminal of the operational amplifier (7) becomes the value of the inverting input terminal (−), namely $−R \cdot I_2$. Since the gain of the operational amplifier (7) generally has a value of about $10^5$, the voltage between the inversion input terminal (−) and non-inverting input terminal (+) is almost 0 [V], and potential between the terminals (5a) and (5b) becomes 0 [V]; that is, the output ends of the secondary coil (4) are in a state which is equivalent to that of the shortcircuiting of the circuit.

Relation of currents $I_1$, $I_2$ and $I_3$ flowing in the primary coil (3), secondary coil (4) and the tertiary coil (22) in such state is elucidated. Now, by providing that numbers of turns of the primary coil (3), the secondary coil (4) and the tertiary coil (22) are $N_1$, $N_2$ and $N_3$, respectively, and winding resistances of the secondary coil (4) and the tertiary coil (22) are $r_2$ and $r_3$, respectively, and magnetic flux generated in the iron core (12) is $\phi$, the following equations hold:

$$E_2 = N_2 \omega \phi$$
$$E_3 = N_3 \omega \phi,$$

wherein $E_2$ and $E_3$ are voltages generated in the secondary coil (4) and the tertiary coil (22), respectively, and $\omega$ is angular frequency of the current. Therefore,

$$E_2 = r_2 \cdot I_2$$
$$E_3 = r_3 \cdot I_3$$

hold, and accordingly, the following are obtained:

$$\frac{E_2}{E_3} = \frac{N_2}{N_3} = \frac{r_2 \cdot I_2}{r_3 \cdot I_3}$$

$$I_3 = \frac{r_2}{r_3} \cdot \frac{N_3}{N_2} \cdot I_2.$$

On the other hand, since the ampere-turns $N_1 \cdot I_1$ generated by the primary coil (3) becomes equal to the ampere-turns generated by the tertiary coil (22), the following holds:

$$N_1 \cdot I_1 = N_2 \cdot I_2 + N_3 \cdot I_3,$$

and from the above-mentioned relations the following hold:

$$N_1 \cdot I_1 = N_2 \cdot I_2 + N_3 \left( \frac{r_2}{r_3} \cdot \frac{N_3}{N_2} \right) \cdot I_2$$

$$= \left( N_2 + \frac{r_2}{r_3} \cdot \frac{N_3}{N_2} \cdot N_3 \right) \cdot I_2,$$

and hence,

$$I_2 = \frac{N_1}{N_2 + \dfrac{r_2}{r_3} \cdot \dfrac{N_3}{N_2} \cdot N_3} \cdot I_1.$$

Now, provided that a relation $I_1$ is 200 [A] and $I_2 = 2$ [mA] is intended to be obtained by, selecting:

$$N_1 = 1 \text{ [T]},$$

$$\frac{r_2}{r_3} = 99,$$

$$\frac{N_3}{N_2} = 1,$$

$$N_2 = 1000 \text{ [T]},$$

$$I_2 = \frac{1}{1000 + 99 \times 1 \times 1000} \times 200 = 2 \times 10^{-3} \text{ [A]}$$

is obtained. That is, when the primary current $I_1$ is 200 [A], the current flowing in the secondary coil can be 2 [mA]. At this time, by making the resistance R of the resistor (6) 1 [KΩ], a voltage of

$$-1[\text{K}\Omega] \times 2[\text{mA}] = -2 \text{ [V]}$$

is obtainable at the output terminal (8a) of the current detection circuit (1).

Here, to obtain the relation of

$$\frac{r_2}{r_3} = 99,$$

$$\frac{N_3}{N_2} = 1,$$

it is enough to wind the secondary coil (4) and the tertiary coil (22), for instance, with the same material of coil, and select the sectional area ratio thereof to be 1:99. This ratio can be accurately maintained by simple winding the secondary coil (4) and the tertiary coil (33) parallelly.

By the way, though the above-mentioned embodiment is described on the case where the secondary coil (4) and the tertiary coil (22) are independent coils, both ones (4) and (22) need not be electrically insulated, and they may be one series coil. Furthermore, though the description is made on the case wherein the secondary coil (4) and the tertiary coil (22) are wound with the same quality material, it is possible that these are of materials having a difference in resistance-temperature coefficients thereof, thus giving a desired temperature characteristic to the current detection circuit (1).

Industrial utility

The present invention is not limited to the current detection means in an electronic type electric energy metering apparatus, but is easily applicable to a convertor for a large current measurement.

Claims

1. A current detection circuit (1) comprising a current transformer (21) which has a primary coil (3) being connected to a pair of input terminals (2a, 2b) for current detection, a secondary coil (4) and an operational amplifier (7) which is connected to said secondary coil (4) of said current transformer (21) and together with a feedback resistor (6) constitutes a current-voltage converter circuit (100) with an input resistance of nearly zero ohms, characterized in that the transformer further comprises a tertiary coil (22) with both ends (23a, 23b) being electrically connected together (24).

2. A current detection circuit as described in claim 1, which is characterized in that said secondary coil and said tertiary coil are wound with the same material in parallel disposition and with substantially the same number of turns.

3. A current detection circuit as described in claim 1, which is characterized in that terminals are provided at both ends and a middle point of one series coil, one side of which is made said secondary coil and the other side of which is made said tertiary coil.

4. A current detection circuit as described in claim 1, which is characterized in that said secondary coil and said tertiary coil are of materials of different resistance-temperature coefficient.

Patentansprüche

1. Stromnachweisschaltkreis (1), welcher einen Stromtransformator (21) aufweist, welche eine Primärspule (3) hat, welche mit einem Paar von Eingangsanschlüssen (2a, 2b) zur Stromdetektion verbunden ist, eine Sekundärspule (4) und einem Operationsverstärker (7) aufweist welcher mit der Sekundärspule (4) des Stromtransformators (21) verbunden ist und zusammen mit einem Rückkopplungswiderstand (6) einen Strom zu Spannungsumsetzerschaltkreis (100) bildet, mit einem Eingangswiderstand von nahezu 0 ohm, dadurch gekennzeichnet, daß der Transformator des weiteren eine Tertiärspule (22) mit beiden Enden (23a, 23b) elektrisch zusammengeschaltet (24) aufweist.

2. Stromnachweisschaltkreis nach Anspruch 1, dadurch gekennzeichnet, daß die Sekundärspule und die Tertiärspule mit dem selben Material mit im wesentlichen der selben Anzahl von Windungen parallel gewickelt sind.

3. Stromnachweisschaltkreis nach Anspruch 1, dadurch gekennzeichnet, daß die Anschlüsse an beiden Enden und einem mittleren Punkt von einer seriellen Spule ausgebildet sind, wobei eine der Seiten die Sekundärspule bildet und die andere der Seiten die Tertiärspule bildet.

4. Stromnachweisschaltkreis nach Anspruch 1, dadurch gekennzeichnet, daß die Sekundärspule und die Tertiärspule aus Materialien mit unterschiedlichen Widerstandstemperaturkoeffizienten sind.

**Revendications**

1. Circuit de détection de courant (1) comprenant un transformateur de courant (21) qui possède un primaire (3) relié à une paire de bornes d'entrée (2a, 2b) pour la détection du courant, un secondaire (4) et un amplificateur asservi (7) qui est relié au secondaire (4) et, conjointement avec une résistance de contre-réaction (6) constitue un circuit de convertisseur de courant-tension (100) avec une résistance d'entrée d'approximativement zéro Ohm, caractérisé en ce que le transformateur comprend de plus un tertiaire (22) dont les deux extrémités (23a, 23b) sont reliées électriquement (24).

2. Circuit de détection de courant selon la revendication 1, caractérisé en ce que le secondaire (4) et le tertiaire (22) sont enroulés avec le même matériau en agencement parallèle et avec sensiblement le même nombre de spires.

3. Circuit de détection de courant selon la revendication 1, caractérisé en ce que les bornes sont munies aux deux extrémités et en un point médian d'une bobine en série dont un côté constitue le secondaire et l'autre côté le tertiaire.

4. Circuit de détection de courant selon la revendication 1, caractérisé en ce que le secondaire et le tertiaire sont en des matériaux ayant des coefficients résistance/température différents.

FIG.1

FIG.2